# EUROPÄISCHE PATENTSCHRIFT

(11) **EP 1 097 616 B1**
(45) Veröffentlichungstag und Bekanntmachung des Hinweises auf die Patenterteilung: **17.09.2003**
(21) Anmeldenummer: 99931234.1
(22) Anmeldetag: 01.07.1999
(51) Int. Cl.: H05K 3/06, H05K 1/02

(54) **VERFAHREN ZUR HERSTELLUNG VON LEITERPLATTEN MIT GROBEN LEITERSTRUKTUREN UND MINDESTENS EINEM BEREICH MIT FEINEN LEITERSTRUKTUREN**
METHOD FOR PRODUCING PRINTED CIRCUIT BOARDS WITH ROUGH CONDUCTING STRUCTURES AND AT LEAST ONE AREA WITH FINE CONDUCTING STRUCTURES
PROCEDE DE PRODUCTION DE PLAQUES CONDUCTRICES COMPORTANT DES STRUCTURES CONDUCTRICES GROSSIERES ET AU MOINS UNE ZONE DOTEE DE STRUCTURES CONDUCTRICES FINES

(30) Priorität: 13.07.1998 DE 19831341
(43) Veröffentlichungstag der Anmeldung: 09.05.2001
(73) Patentinhaber: Siemens S.A., 1060 Bruxelles (BE)
(72) Erfinder: VAN PUYMBROECK, Jozef, B-8020 Oostkamp (BE)
(74) Vertreter: Berg, Peter, Dipl.-Ing.
(86) Internationale Anmeldenummer: EP9904568
(87) Internationale Veröffentlichungsnummer: WO00004750

(56) Entgegenhaltungen:
- EP-A- 0 062 300
- EP-A- 0 602 258
- DE-A- 3 732 249
- DE-A- 4 131 065
- GB-A- 2 213 325
- US-A- 4 312 897
- US-A- 4 527 041

## Beschreibung

Aus der DE 32 45 272 A1 ist ein Verfahren zur Herstellung miniaturisierter Dick- und Dünnschichtschaltungen bekannt, bei dem zum Zwecke einer wesentlichen Erhöhung der Leiterbahndichte zunächst zumindest auf diejenigen Bereiche des Substrats, an denen eine miniaturisierte Leiterbahngeometrie vorgesehen ist, eine vollflächige Schicht aus leitendem Material aufgebracht wird und diese Schicht dann mittels eines nach einem negativen Lay-out-Programm gesteuerten, bezüglich des Substrats justierten Lasers in voneinander getrennte, wenigstens zum Teil jeweils eine Leiterbahn bildende Teilflächen und/oder Streifen unterteilt wird. Beim Anschluß einer Vielzahl von IC-Pads an eine umliegende Peripherie werden durch divergierende Laser-Brennspuren sternförmig auseinanderlaufende Leiterbahnen geschaffen, die IC-seitig sehr schmal und jeweils einem der eng nebeneinanderliegenden Pads zugeordnet sind und die mit ihren verbreiterten, außenliegenden Ende an Peripherieanschlüsse geführt sind. Durch eine spiralförmige Führung der Laser-Brennspur können in der vollflächig leitenden Schicht auch Induktivitäten ausgebildet werden. Dabei läßt sich durch die spiralförmige Anordnung der jeweils zwischen zwei Laser-Brennspuren gelegten Leiterbahn ein sehr kompakter und damit platzsparenden Induktivitätsaufbau erzielen.

Aus der EP 0 602 258 A1 ist ein Verfahren zur Herstellung von Leiterplatten mit groben Leiterstrukturen bekannt, wobei jedoch ein abgegrenzter Bereich dieser Leiterplatten eine sehr hohe Verdrahtungsdichte erhalten soll. Dies wird durch eine zusätzliche Verdrahtungslage erreicht, die nur in dem abgegrenzten Bereich aufgebracht wird und mit der darunter liegenden Verdrahtungslage über Durchkontaktierungen verbunden ist.

Aus der EP 0 062 300 A2 ist ein Verfahren zur Herstellung von Leiterplatten bekannt, bei welchem ein ganzflächig auf eine Metallschicht aufgebrachtes metallisches Ätzresist mittels Laserstrahlung selektiv in den nicht den Leiterstrukturen entsprechenden Bereichen wieder entfernt wird und die Leiterstrukturen durch Abätzen der derart freigelegten Metallschicht gebildet werden.

Aus der DE 41 31 065 A1 ist ein Verfahren zur Herstellung von Leiterplatten bekannt, bei welchem auf ein Substrat nacheinander eine Metallschicht und eine metallische oder organische Ätzresistschicht aufgebracht werden, worauf diese Ätzresistschicht mittels Laserstrahlung in den unmittelbar an das spätere Leiterbahnmuster angrenzenden Bereichen entfernt und die dadurch freigelegte Metallschicht derart weggeätzt wird, daß das Leiterbahnmuster und durch Ätzgräben elektrisch davon isolierte Inselbereiche der Metallschicht auf dem Substrat verbleiben. Die Strukturierung mittels Laserstrahlung kann rasch vorgenommen werden, da die zu entfernenden Bereiche der Ätzresistschicht nur eine geringe Breite aufweisen müssen und die größeren Flächen zwischen zwei Leiterbahnen stehen bleiben.

Der im Anspruch 1 angegebenen Erfindung liegt das Problem zugrunde, ein wirtschaftliches und einfach durchzuführendes Verfahren zur Herstellung von Leiterplatten zu schaffen, die in mindestens einem abgegrenzten Bereich eine hohe Leiterbahndichte aufweisen.

Der Erfindung liegt die Erkenntnis zugrunde, daß durch eine Kombination von konventioneller Photoätztechnik für die Herstellung der groben Leiterstrukturen und der Laserstrukturierung für die Herstellung der feinen Leiterstrukturen die Verfahrensabläufe so aufeinander abgestimmt werden können, daß die Bildung der groben und feinen Leiterstrukturen in einem gemeinsamen Ätzprozeß vorgenommen werden kann.

Die Herstellung der feinen Leiterstrukturen wäre prinzipiell auch in konventioneller Photoätztechnik möglich. Hier müßten jedoch besonders hochwertige Photoresists, besonders hochwertige Lichtquellen und besonders hochwertige Photomasken eingesetzt werden und die Arbeiten in staubfreien Räumen durchgeführt werden. All diese Maßnahmen können durch die Anwendung der Laserstrukturierung für die feinen Leiterstrukturen entfallen, wobei gleichzeitig auch eine sehr hohe Ausbeute erzielt wird.

Im Sinne der Erfindung sind unter groben Leiterstrukturen solche Strukturen mit Leiterbahnbreiten und Leiterbahnabständen von mehr als 100 µm zu verstehen, während unter feinen Leiterstrukturen solche Strukturen mit Leiterbahnbreiten und Leiterbahnabständen von 100 µm und weniger verstanden werden.

Vorteilhafte Ausgestaltungen der Erfindung sind in den Ansprüchen 2 bis 11 angegeben.

Die Ausgestaltung nach Anspruch 2 ermöglicht die Herstellung von Durchkontaktierungen sowohl im Bereich der groben Leiterstrukturen als auch im Bereich der feinen Leiterstrukturen.

Die Weiterbildung nach Anspruch 3 ermöglicht durch die metallische Verstärkungsschicht die Herstellung äußerst zuverlässiger Durchkontaktierungen im Bereich der groben Leiterstrukturen.

Die Ausgestaltung nach Anspruch 4 ermöglicht im Bedarfsfall einen besonders einfachen Schutz des Bereichs mit einen Leiterstrukturen während der Abscheidung der metallischen Verstärkungsschicht im Bereich der groben Leiterstrukturen.

Die Ausgestaltung nach Anspruch 5 ermöglicht im Bereich der feinen Leiterstrukturen eine Strukturierung des Photoresists mit Hilfe eines Laserstrahls. Gemäß Anspruch 6 kann dann in diesem Fall ein Ätzresist besonders einfach und in der gewünschten Struktur in einem Arbeitsgang auf die groben und auf die feinen Leiterstrukturen aufgebracht werden.

Gemäß Anspruch 7 kann der Schutz des Bereichs mit feinen Leiterstrukturen beim Aufbringen der metallischen Verstärkungsschicht auch auf einfache Weise durch eine temporäre Maske bewirkt werden, die danach einfach wieder abgezogen wird.

Die Weiterbildung nach Anspruch 8 ermöglicht eine besonders einfach zu realisierende direkte Laserstrukturierung des Ätzresists im Bereich der feinen Leiterstrukturen.

Obwohl als Ätzresist prinzipiell auch organische Resists, wie z.B. Elektrotauchlack, verwendet werden können, wird gemäß Anspruch 9 eine chemische oder galvanische Abscheidung metallischer Ätzresists bevorzugt. Dabei hat sich gemäß Anspruch 10 die Verwendung von Zinn oder Zinn-Blei als Ätzresist besonders bewährt.

Falls das Ätzresist bei der weiteren Behandlung der Leiterplatte stört, wird es gemäß Anspruch 11 wieder entfernt. In diesem Falle können dann beispielsweise andere Metallschichten auf die groben und auf die feinen Leiterstrukturen aufgebracht werden.

Im folgenden wird ein Ausführungsbeispiel der Erfindung anhand der Zeichnung näher erläutert.

Es zeigen

Figur 1 eine Draufsicht auf eine Leiterplatte mit groben Leiterstrukturen und einem Bereich mit feinen Leiterstrukturen in stark vereinfachter schematischer Darstellung,

Figur 2 verschiedene Verfahrensstadien einer ersten Ausführungsform eines Verfahrens zur Herstellung von Leiterplatten mit groben Leiterstrukturen und einem Bereich mit feinen Leiterstrukturen,

Figur 3 verschiedene Verfahrensstadien einer zweiten Ausführungsform eines Verfahrens zur Herstellung von Leiterplatten mit groben Leiterstrukturen und einem Bereich mit feinen Leiterstrukturen und

Figur 4 verschiedene Verfahrensstadien einer dritten Ausführungsform eines Verfahrens zur Herstellung von Leiterplatten mit groben Leiterstrukturen und einem Bereich mit feinen Leiterstrukturen.

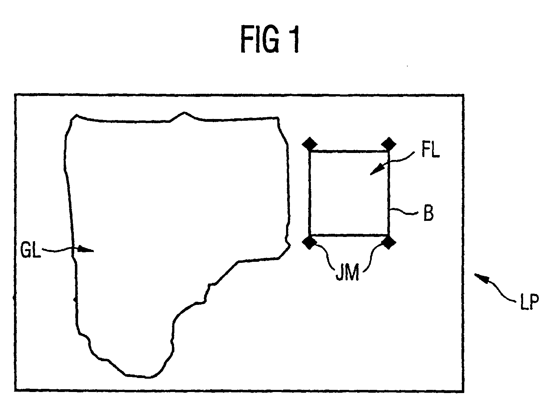

Figur 1 zeigt in stark vereinfachter schematischer Darstellung eine Draufsicht auf eine insgesamt mit LP bezeichnete Leiterplatte, auf deren Oberfläche sich ein nur durch eine Umrißlinie angedeuteter Bereich mit groben Leiterstrukturen GL und ein abgegrenzter Bereich B mit ebenfalls nicht näher erkennbaren feinen Leiterstrukturen FL befinden. In den Eckpunkten des Bereichs B befinden sich vier Justiermarken JM, die bei Arbeiten im Bereich B eine exakte Positionierung der jeweiligen Geräte ermöglichen.

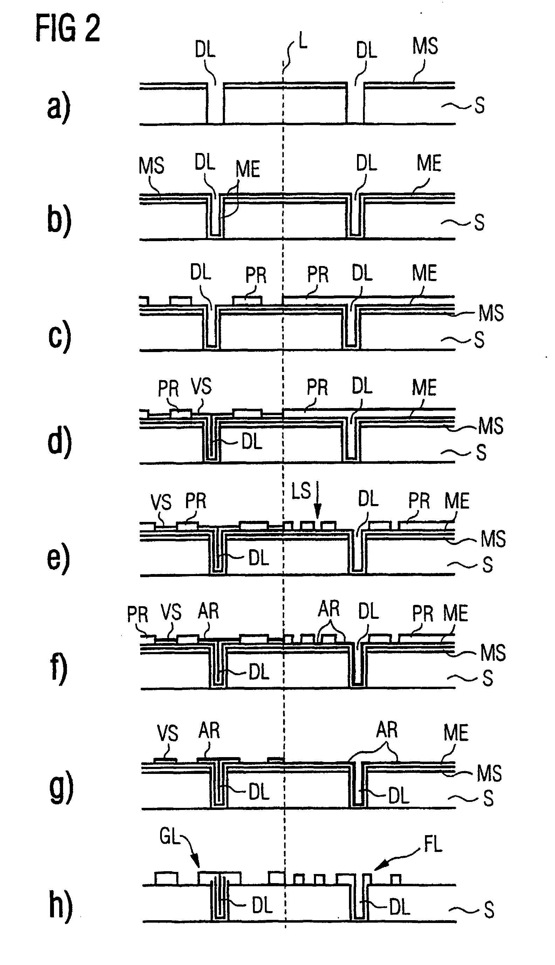

Figur 2 zeigt verschiedene Verfahrensstadien a bis h einer ersten Ausführungsform eines Verfahrens zur Herstellung von Leiterplatten mit groben Leiterstrukturen und einem Bereich mit feinen Leiterstrukturen. Bei den einzelnen Schnitten durch ein elektrisch isolierendes Substrat S befindet sich dabei jeweils links von einer punktierten Linie L der Bereich für die groben Leiterstrukturen, während rechts von dieser punktierten Linie L sich der Bereich der feinen Leiterstrukturen befindet.

Gemäß Figur 2a wird auf das Substrat S eine Metallschicht MS aufgebracht, worauf im Bereich mit groben Leiterstrukturen und im Bereich mit feinen Leiterstrukturen Durchkontaktierungslöcher DL gebohrt werden. Bei der Metallschicht MS handelt es sich z.B. um eine Kupferkaschierung.

Gemäß Figur 2b wird anschließend z.B. durch chemische und galvanische Kupferabscheiung eine Metallisierung ME auf die Metallschicht MS und auf die Wandungen der Durchkontaktierungslöcher DL aufgebracht.

Anschließend wird gemäß Figur 2c ein Photoresist PR aufgebracht und durch Belichten und Entwickeln derart strukturiert, daß es im Bereich der groben Leiterstrukturen ein negatives Muster dieser groben Leiterstrukturen aufweist und andererseits den gesamten Bereich der feinen Leiterstrukturen abdeckt. Gemäß Figur 2d wird dann auf den nicht vom Photoresist PR bedeckten Bereichen der Metallisierung ME und insbesondere in den Durchkontaktierungslöchern DL z.B. durch galvanische Kupferabscheidung eine Verstärkungsschicht VS aufgebracht. Diese Verstärkungsschicht VS hat die Aufgabe, die Zuverlässigkeit der Durchkontaktierungen zu erhöhen.

Gemäß Figur 2e wird dann im Bereich der feinen Leiterstrukturen das Photoresist PR mit Hilfe eines Laserstrahls LS derart strukturiert, daß es das negative Muster der feinen Leiterstrukturen aufweist. Für diese Laserstrukturierung wird beispielsweise ein Nd:YAG Laser mit einer Wellenlänge von 1,06 µm oder von 355 nm verwendet.

Anschließend wird gemäß Figur 2f ein Atzresist AR in einem Arbeitsgang auf die groben Leiterstrukturen und auf die feinen Leiterstrukturen aufgebracht. Im dargestellten Ausführungsbeispiel erfolgt das Aufbringen des Ätzresists AR durch galvanische Abscheidung von Zinn.

Nach der in Figur 2g dargestellten Entfernung des Photoresists PR werden dann gemäß Figur 2h die groben Leiterstrukturen GL und die feinen Leiterstrukturen FL in einem gemeinsamen Ätzprozeß hergestellt. In diesem gemeinsamen Ätzprozeß werden die nicht vom Ätzresist AR geschützten Bereiche der Metallisierung ME und der Metallschicht MS bis zur Oberfläche des Substrats S weggeätzt. In einem letzten Schritt wird dann das verbliebene Ätzresist AR gestrippt.

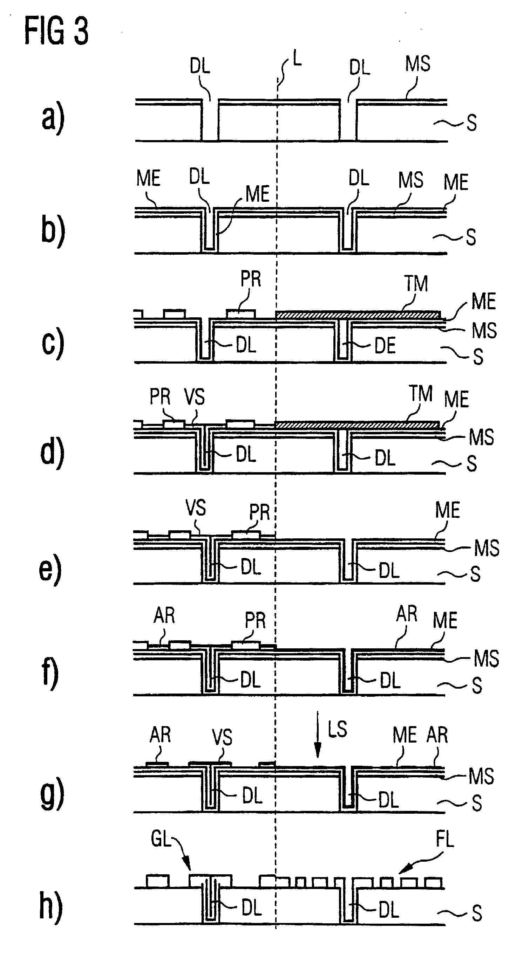

Figur 3 zeigt verschiedene Verfahrensstadien a bis h einer zweiten Ausführungsform eines Verfahrens zur Herstellung von Leiterplatten mit groben Leiterstrukturen und einem Bereich mit feinen Leiterstrukturen. Die Figuren 3a und 3b entsprechen dabei den bereits beschriebenen Figuren 2a und 2b.

Gemäß Figur 3c wird auf die Metallisierung ME ein Photoresist PR aufgebracht und durch Belichten und Entwickeln derart strukturiert, daß es im Bereich der groben Leiterstrukturen ein negatives Muster dieser groben Leiterstrukturen aufweist. Im Bereich der feinen Leiterstrukturen wird eine mit TM bezeichnete temporäre Maske auf die Metallisierung ME aufgebracht. Anschließend wird gemäß Figur 3d im Bereich der groben Leiterstrukturen eine Verstärkungsschicht VS auf die Metallisierung ME aufgebracht.

Nach dem Abziehen der temporären Maske TM gemäß Figur 3e wird dann gemäß Figur 3f ein Ätzresist AR in einem Arbeitsgang auf die groben Leiterstrukturen und auf den Bereich der feinen Leiterstrukturen aufgebracht. Im dargestellten Ausführungsbeispiel erfolgt die Aufbringung des Ätzresists AR durch chemische Abscheidung von Zinn.

Gemäß Figur 3g werden anschließend das Photoresist PR entfernt und das Ätzresist AR im Bereich der feinen Leiterstrukturen mit Hilfe eines Laserstrahls LS derart strukturiert, daß es das Muster der feinen Leiterstrukturen aufweist. Für diese Laserstruturierung des Ätzresists AR wird ein Nd:YAG Laser mit einer Wellenlänge von 1,06 µm verwendet.

Gemäß Figur 3h werden dann die groben Leiterstrukturen GL und die feinen Leiterstrukturen FL in einem gemeinsamen Ätzprozeß hergestellt. In diesem gemeinsamen Ätzprozeß werden die nicht vom Ätzresist AR geschützten Bereiche der Metallisierung ME und der Metallschicht MS bis zur Oberfläche des Substrats S weggeätzt. In einem letzten Schritt wird dann auch hier wieder das verbliebene Ätzresist AR gestrippt.

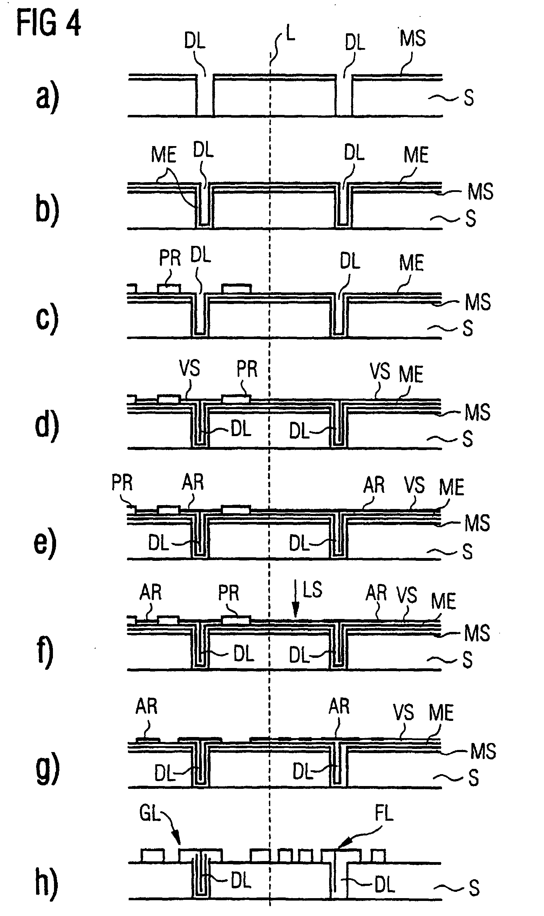

Figur 4 zeigt verschiedene Verfahrensstadien a bis h einer dritten Ausführungsform eines Verfahrens zur Herstellung von Leiterplatten mit groben Leiterstrukturen und einem Bereich mit feinen Leiterstrukturen. Die Figuren 4a und 4b entsprechen den bereits beschriebenen Figuren 2a und 2b.

Gemäß Figur 4c wird auf die Metallisierung ME ein Photoresist PR aufgebracht und durch Belichten und Entwickeln derart strukturiert, daß es im Bereich der groben Leiterstrukturen ein negatives Muster dieser groben Leiterstrukturen aufweist.

Anschließend wird gemäß Figur 4d eine Verstärkungsschicht VS auf die Metallisierung ME aufgebracht, wobei diese Verstärkungsschicht VS den gesamten Bereich der feinen Leiterstrukturen ganzflächig bedeckt.

Gemäß Figur 4e wird dann ein Ätzresist AR auf die Verstärkungsschicht VS aufgebracht. Im dargestellten Ausführungsbeispiel erfolgt die Aufbringung des Ätzresists AR durch chemische Abscheidung von Zinn.

Gemäß Figur 4f wird anschließend das Ätzresist AR im Bereich der feinen Leiterstrukturen mit Hilfe eines Laserstrahls LS derart strukturiert, daß es das Muster der feinen Leiterstrukturen aufweist. Für diese Laserstrukturierung des Ätzresists AR wird ein Nd:YAG Laser mit einer Wellenlänge von 1,06 µm verwendet.

Nach dieser Laserstrukturierung wird gemäß Figur 4g das Photoresist PR entfernt.

Gemäß Figur 4h werden dann die groben Leiterstrukturen GL und die feinen Leiterstrukturen FL in einem gemeinsamen Ätzprozeß hergestellt. Dabei werden im Bereich der groben Leiterstrukturen GL die nicht vom Ätzresist AR geschützten Bereiche der Metallisierung ME und der Metallschicht MS bis zur Oberfläche des Substrats S abgeätzt. Im Bereich der feinen Leiterstrukturen FL werden die nicht vom Ätzresist AR geschützten Bereiche der Verstärkungsschicht VS, der Metallisierung ME und der Metallschicht MS bis zur Oberfläche des Substrats S abgeätzt. Nach diesem gemeinsamen Ätzprozeß wird das verbliebene Ätzresist AR gestrippt.

## Patentansprüche

1. Verfahren zur Herstellung von Leiterplatten (LP) mit groben Leiterstrukturen (GL), nämlich mit Leiterbahnbreiten und Leiterbahnabständen von mehr als 100 µm, und mit mindestens einem abgegrenzten Bereich (B) mit feinen Leiterstrukturen (FL), nämlich mit Leiterbahnbreiten und Leiterbahnabständen von 100 µm und weniger, mit folgenden Schritten:
a) auf ein elektrisch isolierendes Substrat (S) wird eine Metallschicht (MS) aufgebracht;
b) im Bereich der groben Leiterstrukturen (GL) wird ein mittels Photolithographie strukturiertes Ätzresist (AR) auf die Metallschicht (MS) aufgebracht, welches das Muster der groben Leiterstrukturen (GL) aufweist;
c) im Bereich (B) der feinen Leiterstrukturen (FL) wird ein mit Hilfe eines Laserstrahls (LS) strukturiertes Ätzresist (AR) auf die Metallschicht (MS) aufgebracht, welches das Muster der feinen Leiterstrukturen (FL) aufweist;
d) zur Bildung der groben Leiterstrukturen (GL) und der feinen Leiterstrukturen (FL) werden in einem gemeinsamen Ätzprozeß die nicht durch ein Ätzresist (AR) geschützten Bereiche der Metallschicht (MS) bis zur Oberfläche des Substrats (S) weggeätzt.

2. Verfahren nach Anspruch 1,
**dadurch gekennzeichnet ,**
**daß** im Bereich der groben Leiterstrukturen (GL) und/oder im Bereich der feinen Leiterstrukturen (FL) Durchkontaktierungslöcher (DL) in die Metallschicht (MS) und das Substrat (S) eingebracht werden und daß dann auf die Metallschicht (MS) und auf die Wandungen der Durchkontaktierungslöcher (DL) eine Metallisierung (ME) aufgebracht wird.

3. Verfahren nach Anspruch 2,
**dadurch gekennzeichnet ,**
**daß** auf die Metallisierung (ME) zumindest im Bereich der groben Leiterstrukturen (GL) ein Photoresist (PR) aufgebracht und durch Belichten und Entwickeln derart strukturiert wird, daß es das negative Muster der groben Leiterstrukturen (GL) aufweist und daß dann eine metallische Verstärkungsschicht (VS) auf die Metallisierung (ME) aufgebracht wird.

4. Verfahren nach Anspruch 3,
**dadurch gekennzeichnet,**
**daß** das Photoresist (PR) auch auf den Bereich (B) mit feinen Leiterstrukturen (FL) aufgebracht wird und diesen beim Aufbringen der metallischen Verstärkungsschicht (VS) abdeckt.

5. Verfahren nach Anspruch 4,
**dadurch gekennzeichnet,**
**daß** das Photoresist (PR) nach dem Aufbringen der metallischen Verstärkungsschicht (VS) im Bereich (B) mit feinen Leiterstrukturen (FL) mit Hilfe eines Laserstrahls (LS) derart strukturiert wird, daß es das negative Muster der feinen Leiterstrukturen (LS) aufweist.

6. Verfahren nach Anspruch 5,
**dadurch gekennzeichnet,**
**daß** das Ätzresist (AR) in einem Arbeitsgang auf die groben Leiterstrukturen (GL) und auf die feinen Leiterstrukturen (FL) aufgebracht wird und daß dann das Photoresist (PR) entfernt wird.

7. Verfahren nach Anspruch 3,
**dadurch gekennzeichnet,**
**daß** der Bereich (B) mit feinen Leiterstrukturen (FL) beim Aufbringen der metallischen Verstärkungsschicht (VS) durch eine temporäre Maske (TM) abgedeckt wird.

8. Verfahren nach einem der Ansprüche 1 bis 3 oder 7,
**dadurch gekennzeichnet,**
**daß** im Schritt c) das Atzresist (AR) ganzflächig auf die Metallschicht (MS) aufgebracht und mit Hilfe des Laserstrahls (LS) derart strukturiert wird, daß es das Muster der feinen Leiterstrukturen (FL) aufweist.

9. Verfahren nach einem der vorhergehenden Ansprüche, **dadurch gekennzeichnet,**
**daß** das Ätzresist (AR) durch chemische oder galvanische Metallabscheidung in einem Arbeitsgang im Bereich mit groben Leiterstrukturen (GL) und im Bereich (B) mit feinen Leiterstrukturen (FL) aufgebracht wird.

10. Verfahren nach Anspruch 9,
**dadurch gekennzeichnet,**
**daß** als Ätzresist (AR) Zinn oder Zinn-Blei verwendnet wird.

11. Verfahren nach einem der vorhergehenden Ansprüche, **dadurch gekennzeichnet,**
**daß** das Ätzresist (AR) nach dem Schritt d) wieder entfernt wird.

## Claims

1. Method for producing printed circuit boards (LP) having coarse conductor structures (GL), namely having conductor track widths and conductor track spacings of more than 100µm, and having at least one delimited region (B) having fine conductor structures (FL), namely having conductor track widths and conductor track spacing of 100µm and less, having the following steps:
a) a metal layer (MS) is applied to an electrically insulating substrate (S);
b) in the region of the coarse conductor structures (GL), an etching resist (AR) patterned by means of photolithogrpahy is applied to the metal layer (MS), which resist has the pattern of the coarse conductor structures (GL);
c) in the region (B) of the fine conductor structures (FL), an etching resist (AR) patterned with the aid of a laser beam (LS) is applied to the metal layer (MS), which resist has the pattern of the fine conductor structures (FL);
d) in order to form the coarse conductor structures (GL) and the fine conductor structures (FL), those regions of the metal layer (MS) which are not protected by an etching resist (AR) are etched away as far as the surface of the substrate (S) in a common etching process.

2. Method according to Claim 1,
**characterized**
**in that**, in the region of the coarse conductor structures (GL) and/or in the region of the fine conductor structures (FL), plated-through holes (DL) are introduced into the metal layer (MS) and the substrate (S), and in that a metallization layer (ME) is then applied to the metal layer (MS) and to the walls of the plated-through holes (DL).

3. Method according to Claim 2,
**characterized**
**in that** a photoresist (PR) is applied to the metallization layer (ME) at least in the region of the coarse conductor structures (GL) and is patterned by exposure and development in such a way that it has the negative pattern of the coarse conductor structures (GL), and in that a metallic reinforcing layer (VS) is then applied to the metallization layer (ME).

4. Method according to Claim 3,
**characterized**
**in that** the photoresist (PR) is also applied to the region (B) having fine conductor structures (FL) and covers said region during the application of the metallic reinforcing layer (VS).

5. Method according to Claim 4,
**characterized**
**in that** the photoresist (PR) is patterned after the application of the metallic reinforcing layer (VS) in the region (B) having fine conductor structures (FL) with the aid of a laser beam (LS) in such a way that it has the negative pattern of the fine conductor structures (LS).

6. Method according to Claim 5,
**characterized**
**in that** the etching resist AR) is applied to the coarse conductor structures (GL) and to the fine conductor structures (FL) in one work operation, and in that the photoresist (PR) is then removed.

7. Method according to Claim 3,
**characterized**
**in that** the region (B) having fine conductor structures (FL) is covered by a temporary mask (TM) during the application of the metallic reinforcing layer (VS).

8. Method according to one of Claims 1 to 3 or 7,
**characterized**
**in that**, in step c), the etching resist (AR) is applied over the whole area of the metal layer (MS) and is patterned with the aid of the laser beam (LS) in such a way that it has the pattern of the fine conductor structures (FL).

9. Method according to one of the preceding claims,
**characterized**
**in that** the etching resist (AR) is applied by chemical or electrical metal deposition in one work operation in the region having coarse conductor structures (GL) and in the region (B) having fine conductor structures (FL).

10. Method according to Claim 9,
**characterized**
**in that** tin or tin-lead is used as the etching resist (AR).

11. Method according to one of the preceding claims,
**characterized**
**in that** the etching resist (AR) is removed again after step d).

## Revendications

1. Procédé de production de plaques conductrices (LP) comportant des structures conductrices grossières (GL), à savoir des largeurs de pistes conductrices et des écarts de pistes conductrices supérieurs à 100 µm, et au moins une zone (B) délimitée, dotée de structures conductrices fines (FL), à savoir des largeurs de pistes conductrices et des écarts de pistes conductrices inférieurs ou égaux à 100 µm, selon les étapes suivantes :
a) une couche métallique (MS) est appliquée sur un substrat (S) électriquement isolant ;
b) une couche de produit non dégradable par attaque corrosive (AR) structurée par lithophotographie est appliquée sur la couche métallique (MS) dans la zone dotée de structures conductrices grossières (GL), cette réserve présente la trame des structures conductrices grossières (GL),
c) une couche de produit non dégradable par attaque corrosive (AR) structurée par un rayon laser (LS) est appliquée sur la couche métallique (MS) dans la zone (B) dotée de structures conductrices fines (FL), cette réserve présente la trame des structures conductrices fines (FL),
d) pour la formation de structures conductrices grossières (GL) et de structures conductrices fines (FL), les zones de la couche métallique (MS) qui ne sont pas protégées par une couche de produit non dégradable par attaque corrosive sont décapées à l'acide jusqu'à la surface du substrat (S) dans un processus de gravure commun.

2. Procédé selon la revendication 1, **caractérisé en ce que,** dans la zone dotée de structures conductrices grossières (GL) et/ou dans la zone dotée de structures conductrices fines (FL), des trous de métallisation (DL) sont pratiqués dans la couche métallique (MS) et le substrat (S), et **qu'**ensuite une métallisation (ME) est appliquée sur la couche métallique (MS) et sur les parois des trous de métallisation (DL).

3. Procédé selon la revendication 2, **caractérisé en ce qu**'une couche de produit non dégradable par influence photochimique (PR) est appliquée sur la métallisation (ME), au moins dans la zone dotée de structures conductrices grossières (GL), et structurée par exposition et développement de telle sorte qu'elle présente la trame négative des structures conductrices grossières (GL) et **en ce qu**'ensuite une couche de renforcement métallique (VS) est appliquée sur la métallisation (ME).

4. Procédé selon la revendication 3, **caractérisé en ce que** la couche de produit non dégradable par influence photochimique (PR) est appliquée aussi sur la zone (B) dotée de structures conductrices fines (FL), et recouvre celle-ci lors de l'application de la couche de renforcement (VS) métallique.

5. Procédé selon la revendication 4, **caractérisé en ce que** la couche de produit non dégradable par influence photochimique (PR) est structurée par un rayon laser (LS) après l'application de. la couche de renforcement métallique (VS) dans la zone (B) dotée de structures conductrices fines (FL) de telle sorte qu'elle présente la trame négative de structures conductrices fines (FL).

6. Procédé selon la revendication 5, **caractérisé en ce que** la couche de produit non dégradable par attaque corrosive (AR) est appliquée sur les structures conductrices grossières (GL) et sur les structures conductrices fines (FL) lors d'une opération et qu'ensuite la couche de produit non dégradable par influence photochimique (PR) est enlevée.

7. Procédé selon la revendication 3, **caractérisé en ce que** la zone (B) dotée de structures conductrices fines (FL), est recouverte par un masque temporaire (TM) lors de l'application de la couche de renforcement métallique (VS).

8. Procédé selon l'une des revendications 1 à 3 ou 7, **caractérisé en ce que,** lors de l'étape c), la couche de produit non dégradable par attaque corrosive (AR) est appliquée sur toute la surface de la couche métallique (MS) et structurée par le rayon laser (LS) de telle sorte qu'elle présente la trame des structures conductrices fines (FL).

9. Procédé selon l'une des revendications précédentes, **caractérisé en ce que** la couche de produit non dégradable par attaque corrosive (AR) est appliquée sur la zone dotée de structures conductrices grossières (GL), et sur la zone (B) dotée de structures conductrices fines (FL) par dépôt électrolytique chimique ou galvanique en une opération.

10. Procédé selon la revendication 9, **caractérisé en ce que** l'on utilise de l'étain ou de l'étain plomb comme couche de produit non dégradable par attaque corrosive (AR).

11. Procédé selon l'une des revendications précédentes, **caractérisé en ce que la** couche de produit non dégradable par attaque corrosive (AR) est de nouveau enlevée après l'étape d).
